**Europäisches Patentamt**

**European Patent Office**

**Office européen des brevets**

(19)

(11) Veröffentlichungsnummer: **0 184 849**
A1

(12) # EUROPÄISCHE PATENTANMELDUNG

(21) Anmeldenummer: **85115884.0**

(22) Anmeldetag: **12.12.85**

(51) Int. Cl.⁴: **H 01 L 23/54,** H 05 F 3/02, B 65 D 85/42

(30) Priorität: **12.12.84 DE 8436362 U**

(43) Veröffentlichungstag der Anmeldung: **18.06.86** Patentblatt 86/25

(84) Benannte Vertragsstaaten: **AT BE CH DE FR GB IT LI NL**

(71) Anmelder: **Bauer, Rainer, An der Dampfmühle 12, D-6072 Dreieich (DE)**

(72) Erfinder: **Bauer, Rainer, An der Dampfmühle 12, D-6072 Dreieich (DE)**

(74) Vertreter: **Dipl.-Ing. H.G. Görtz, Dr.-Ing. J.H. Fuchs Patentanwälte, Sonnenberger Strasse 100 Postfach 26 26, D-6200 Wiesbaden (DE)**

(54) **Aufnahmeeinrichtung für elektronische Bauelemente.**

(57) Beschrieben ist eine eine Schaumstoffplatte (2) aufweisende Aufnahmeeinrichtung für elektronische Bauelemente, insbesondere integrierte Schaltkreise (9), die an ihrer Oberfläche mit einer beschriftbaren und elektrisch leitenden Folie (4) kaschiert ist, und in die die integrierten Schaltkreise (9) mit ihren Anschlussbeinen einsteckbar sind. Neben den integrierten Schaltkreisen (9) können mit handelsüblichen Schreibgeräten Kennzeichnungen (11) angebracht werden. Die so ausgebildete Trägerplatte (1) kann in einem kassettenartigen Gehäuse (6, 7, 8, 13) angeordnet sein, welches die gekennzeichnete und übersichtliche Anordnung von elektronischen Bauelementen für Service-Techniker ermöglicht. Das Gehäuse kann zusätzlich strahlungsgesichert ausgeführt sein.

EP 0 184 849 A1

0184849

B 188
09. Dezember 1985
Fu/Ra.

Aufnahmeeinrichtung für elektronische Bauelemente

---

Die Erfindung betrifft eine Aufnahmeeinrichtung für elektrische Bauelemente, insbesondere integrierte Schaltkreise, welche mit im wesentlichen parallelen, vom Bauelement weggerichteten Anschlußbeinen versehen sind, mit denen diese Bauelemente in eine Fläche der Aufnahmeeinrichtung einsteckbar sind, die dieserhalb ein leicht von den Anschlußbeinen durchbohrbares, u.a. schaumstoffartiges Material aufweist, wobei die Aufnahmeeinrichtung im Bereich der einzusteckenden Anschlußbeine eine elektrische Leitfähigkeit aufweist, um die gehaltenen elektronischen Bauelemente durch eine ladungsableitende gegenseitige elektrische Verbindung vor Schädigungen zu schützen.

Wenn im Sinne dieser Anmeldung von einer Aufnahmeeinrichtung für elektronische Bauelemente gesprochen wird, so ist hiermit eine Einrichtung für Bauelemente gemeint, die sich nicht in ihrem Einbauzustand befinden, sondern die der Lagerung, dem Transport sowie der insbesondere übersichtlichen Aufbewahrung solcher Bauelemente dient. Elektronische Bauelemente, insbesondere integrierte Schaltkreise sind im uneingebauten Zustand bekanntlicherweise verhältnismäßig empfindlich, so daß sie bei Lagerung und Transport einerseits vor mechanischen Beschädigungen, andererseits aber auch vor elektrostatischen Aufladungen zu schützen sind, die zu einer inneren elektrischen Beschädigung der Bauelemente bei programmierten Bauelementen insbesondere zur Löschung der Information führen können.

Es sind bereits einfache Schaumstoffplatten von etwa 5 bis 10 mm Dicke bekannt, die aus einem, eine gewisse Steifigkeit aufweisenden Weichschaum bestehen, dem zum Erzeugen einer entsprechenden elektrischen Leitfähigkeit ein Leitfähigkeitsmittel wie beispielsweise Graphit zugegeben ist. Diese Schaumstoffplatten weisen eine sehr dunkle bis schwarze Farbe auf und haben eine verhältnismäßig grobporige Oberfläche, in die sich integrierte Schaltkreise mit ihren Anschlußbeinen hineinstecken lassen. Das Leitfähigkeitsmittel in dem Schaumstoff führt dazu, daß die einzelnen Anschlußbeine des Bauelementes elektrisch leitend miteinander verbunden sind, so daß sich zwischen den einzelnen Anschlüssen eventuell bildende elektrostatische Aufladungen durch elektrische Leitung ausgleichen können. Elektrisch leitende Schaumstoffplatten sind verhältnismäßig teuer. Diese Schaumstoffplatten dienen im wesentlichen dazu, herstellerseitig elektronische Bauelemente ein und desselben Typs für den Versand auf ihnen anzuordnen. Es sind auch schon Schaumstoffplatten bekannt, die an ihrer Oberfläche eine im wesentlichen geschlossene Haut vom Aufschäumen des Materials her aufweisen, oder sogar eine Art Folienkaschierung, wobei diese Folie ein Leitfähigkeitsmittel enthält. Auch hierfür wird im allgemeinen Graphit oder ein kohlenstoffhaltiges Material verwendet, so daß diese Schaumstoffplatten schwarz in ihrer Färbung sind. Außerdem ist ihre Oberflächenstruktur narbig und rauh.

Nun besteht aber nicht nur ein Bedarf an derartigen Trägern für integrierte Schaltkreise zur Versandausrüstung vom Hersteller her. Ein Service-Techniker, der gerufen wird, um einen Schaden an einem elektrischen Gerät zu beseitigen, muß in der Regel eine Vielzahl verschiedener elektronischer Bauelemente mit sich führen, um für alle möglichen Eventualitäten ausgerüstet zu sein. Gleichzeitig soll das Auswechseln des oder der Bauelemente aus Kosten- und Zeitgründen möglichst schnell vor sich gehen. In der Regel fehlt es dem Service-Techniker an einer übersichtlichen Aufbewahrungsmöglichkeit für die verschiedenen elektronischen Bauelemente, so daß ein schnelles Auswählen des benötigten Bauelementes nicht gewährleistet ist. Insbesondere ist es häufig notwendig, jedes einzelne Bauelement in die Hand zu nehmen, um anhand des kleinen Typenaufdrucks auszumachen, ob es sich um das gewünschte Bauelement handelt oder nicht.

Der vorliegenden Erfindung liegt daher in erster Linie die Aufgabe zugrunde, eine Aufnahmeeinrichtung der eingangs genannten Art für elektronische Bauelemente zu schaffen, die diese Bauelemente nicht nur vor mechanischen Beschädigungen schützt und eine elektrisch leitende Verbindung zwischen den Anschlußbeinen gewährleistet, um für eine Ableitung elektrostatischer Ladungen zu sorgen, sondern die es insbesondere dem Service-Techniker auch ermöglicht, Bauteile in übersichtlicher Form anzuordnen, wobei jedem Bauteil mit gebrauchsüblichen Mitteln eine gut sichtbare Kennzeichnung zugeordnet werden kann, so daß die Bauteile gut erkennbar und unterscheidbar sind, ohne sie ihrem Träger entnehmen zu müssen. In besonderer Ausführungsform soll die Aufnahmeeinrichtung zusätzlich eine besonders gute Handhabbarkeit aufweisen, so daß sie in Service-Koffern oder anderen Behältnissen problemlos mitgeführt werden kann, ohne daß ein besonderes Augenmerk auf die Schonung der elektronischen Bauelemente gelegt zu werden braucht.

Diese Aufgabe wird erfindungsgemäß dadurch gelöst, daß die Einsteckfläche der Afnahmeeinrichtung eine von den Anschlußbeinen des elektronischen Bauelementes durchstechbare, auf ihrer freien Außenoberfläche mit einem handelsüblichen Schreibgerät beschriftbare Folie aufweist, unter der das schaumstoffartige Material angeordnet ist, wobei diese Außenoberfläche einen genügend niedrigen Lichtabsorptionsgrad aufweist, um auf ihr angebrachte Informationen mit genügendem Kontrast dem menschlichen Auge erkennbar zu machen.

Wenn hier von einer Folie die Rede ist, die mit handelsüblichen Mitteln beschriftbar sein soll, so ist dabei unter anderem an Faserschreiber oder Filzschreiber gedacht, wie sie beispielsweise zur Beschriftung von Folien für Over-Head-Projektoren geläufig sind. Solche Schreiber sind überall im Handel erhältlich. Für die Beschriftbarkeit ist es ferner angebracht, daß die Folie möglichst nicht die genarbte oder Porenstruktur der darunterliegenden Schaumstoffplatte aufweist, weil dann eine Beschriftung ihrer Oberfläche nicht in ausreichend kleinem Maße möglich ist. Wenn hier von einem geringen Absorptionsgrad der Oberfläche für Licht zum Zwecke des Gewährleistens eines bestimmten Kontrastes gegenüber den aufgebrachten Schriftzeichen gesprochen wird, so soll hierunter ein Absorptionsgrad der Oberfläche von weniger als 0,8 verstanden werden.

Das unterhalb der Folie verwendete schaumstoffartige Material sollte eine im wesentlichen steife Hartschaumplatte sein, die für die Handhabung eine genügende Eigenstabilität aufweist, die aber eine ausreichende Weichheit bzw. Durchdringungsfähigkeit besitzt, um die Anschlußbeine der elektronischen Bauelemente ohne Beschädigung und Verbiegen einstecken zu können. Die beschriftbare Folie ist auf die Hartschaumplatte aufkaschiert.

Die Folie kann grundsätzlich eine Kunststoffolie sein, die jedoch zum Erzeugen der erforderlichen Kontrastfähigkeit ein möglichst opakes helles Pigment enthalten sollte. Die elektrische Leitfähigkeit der Einsteckfläche kann entweder durch eine entsprechend leitfähige Beschichtung der Folie gegeben sein, die beispielsweise aus Zinnoxid oder Indiumoxid besteht, sie kann aber auch, wie bereits bekannt, durch entsprechende Ausrüstung des Schaumstoffmaterials vorgegeben werden, obwohl diese Ausführung teuer ist und den Nachteil hat, durch Berührung entstehende, elektrostatische Oberflächenladungen der Folie nicht genügend abzu-leiten.

Eine besonders vorteilhafte Ausführungsform der Erfindung besteht darin, als beschriftbare Folie eine Metallfolie, insbesondere eine Aluminiumfolie zu verwenden, die auf das durch die Anschlußbeine der Bauelemente durchdringbare Plattenmaterial aufkaschiert ist. Eine Aluminiumfolie weist nicht nur eine erstklassige elektrische Leitfähigkeit auf, sie ist bei entsprechender Dickenausführung, wie sie im Haushalts- und Verpackungssektor üblich ist, durch die empfindlichen Beine der elektronischen Bauelemente leicht durchstechbar und weist nicht den anfänglichen Durchdringungswiderstand aus, wie er bei Kunststoffolien beobachtet wird, die sich oft erst nach erheblicher Verformung und Eindrückung der Oberfläche durchstechen lassen. Die gewisse Tendenz einer Aluminiumfolie, an den Durchstichstellen leicht weiter aufzureißen, wodurch ein elektrischer Kontakt mit den Anschlußbeinen des elektronischen Bauteiles in Frage gestellt werden könnte, läßt sich vorteilhafterweise dadurch verringern, daß man eine Aluminiumfolie verwendet, die mit einer Papierschicht kaschiert ist. Solche papierkaschierten Aluminiumfolien sind problemlos herstellbar und aus dem Verpackungssektor bekannt. Die Papierschicht ist an derjenigen Seite der Folie anzuodrnen, die der Schaumstoffplatte zugewandt ist. Hieraus resultiert der weitere Vorteil, daß sich die Aluminiumfolie mittels der Papierschicht leicht auf eine Schaumstoffplatte aufkaschieren läßt, was

0184849

bei Verwendung einer reinen Metallfolie auf gewisse Schwierigkeiten stoßen könnte. Aluminiumfolien lassen sich in ihrer Oberfläche durchaus so ausrüsten, daß sie mit den erwähnten Schreibgeräten leicht beschriftbar sind. Eine entsprechende Kontrastwirkung ist bei der Aluminiumfolie auch gegeben. Wenn im vorliegenden Zusammenhang von Aluminiumfolien gesprochen wird, so soll dieser Begriff nicht auf die handelsübliche Definition beschränkt sein, der Folien von 7 µ bis etwa 20 µ Diehl umfaßt, sondern auch das sogenannte Aluminiumdünnband mit umfassen, welches den Dickenbereich von etwa 20 µ bis 0,2 mm einschließt. Es bereitet dem Fachmann keine Schwiereigkeiten aus den angegebenen Dickenbereichen eine geeignete Folie für die Erfindung auszuwählen. Bei papierkaschierten Aluminiumfolien wird im allgemeinen ein Trägerpapier von 50 g/m² verwendet. Bei der Verwendung einer solchen kaschierten Folie kann die Aluminiumschicht natürlich entsprechend dünner sein, da auch dünnste Folien in jedem Fall noch die geforderten Leitfähigkeitseigenschaften aufweisen.

Der besondere Vorteil dieser bevorzugten Ausführungsform der Erfindung beruht darin, daß gerade die Oberfläche der Aufnahmeeinrichtung eine hohe Leitfähigkeit aufweist, so daß elktrostatische Oberflächenladungen, die bei Kunststoffmaterialien allein durch Berühren schon entstehen können, sich hier nicht ausbilden können.

Bei der Herstellung von Aluminiumfolien fallen diese herstellungsbedingt mit einer glänzenden und einer matten Seite an. Während für Verpackungszwecke meist die matte Seite mit der Papierschicht kaschiert wird, ist es für eine Verwendung im Rahmen dieser Erfindung besonders zweckmäßig, die matte Seite der Aluminiumfolie als Oberfläche der Aufnahmeeinrichtung zu verwenden. Beschriftungen weisen auf der matten Seite einen besseren Kontrast auf und lassen sich daher besser erkennen. Zweckmäßigerweise werden für die erfindungsgemäße Aufnahmeeinrichtung Hartschaumplatten im Dickenbereich von 5-10 mm verwendet.

Eine bevorzugte Ausführungsform der Aufnahmeeinrichtung besteht darin, beide Seiten der Hartschaumplatte mit einer Aluminiumfolie zu versehen. Dies hat nicht nur den Vorteil, daß solche Trägerplatten durch Wenden auch noch von der anderen Seite durch Gebrauch bereits stark zerstochen oder mit nicht mehr benötigten Informationen versehen ist, die doppelseitige Belegung der Hartschaumplatte mit einer Aluminiumfolie hat auch den Vorteil, daß die Platte sichwechselnden Temperatureinflüssen weniger verwirft oder krümmt.

Bei der vorstehend beschriebenen bevorzugten Ausführungsform unter Verwendung einer Metall-, insbesondere Aluminiumfolie, bietet sich natürlich auch die Möglichkeit, die Folie von vornherein im Druckwege mit bestimmten Anordnungsfeldern für die elektronischen Bauelemente und/oder erforderlichen Informationen zu versehen. Eine solche Ausführung des erfindungsgemäßen Plattenmaterials kann auch für dessen Verwendung für den herstellerseitigen Versand von besonderem Interesse sein. Typenbezeichnungen, Bauelementinformationen und Firmen- bzw. Werbeangaben können von vornherein auf der erfindungsgemäßen Aufnahmeeinrichtung angebracht werden.

Ein besonderer Aspekt der Erfindung in bevorzugter Ausführungsform liegt jedoch darin, die Aufnahmeeinrichtung in Gestalt eines Behälters oder einer Kassette auszubilden, die darüber hinaus in einem Format ausgeführt ist, daß sie dem Service-Techniker eine einfache Handhabbarkeit bietet, d.h. in normalen Service-Koffern und Aktentaschen mitführbar ist. Hier kommen Größen im Format DIN A4 oder auch kleiner in Frage. Vorteilhafterweise weist eine solche Einheit eine Mehrzahl der erfindungsgemäß ausgebildeten Einsteckflächen auf. Wenn hier von Behältern oder Kassetten die Rede ist, so können darunter sowohl ringbuchartige Anordnungen verstanden werden, in die die einzelnen Einsteckflächen bzw. Einsteckplatten seitenartig eingehängt sind, wie auch mit Deckel versehene, geschlosse Kassetten, wie sie beispielsweise heute für die Aufnahme von elektronischen Speicherdisketten verwendet werden. Bei erfindungsgemäßer Ausführung der Einsteckflächen kann der Service-Techniker ein von ihm benötigtes Sortiment an elektronischen Bauteilen in die Flächen einstecken und neben den Bauteilen eine benötigte Kennzeichnung oder Informationsbeschriftung anbringen. Es ist auch möglich, derartige Kennzeichnungen von vornherein durch Aufdruck vorzugeben, so daß bestimmte Bauelemente an einem speziell dafür vorgesehenen Platz angeordnet werden können. Aber auch in diesem Fall ist dann zusätzlich die Möglichkeit gegeben, daß der Benutzer der Aufnahmeeinrichtung noch eigene Informationen hinzufügen kann.

In weiterhin bevorzugter Ausführungsform ist die Kassette, das Gehäuse oder der Behälter selbst mit einer elektrisch leitenden Beschichtung oder Ausrüstung versehen, um elektrostatische Ladungen ableiten zu können, bevor diese überhaupt in den Bereich der gehalterten elektronischen Bauelemente gelangen können. Auch diese elektrische Leitfähigkeitsausrüstung des Gehäuses kann durch eine Aluminiumfolienkaschierung erreicht werden. Ferner kann es zweckmäßig sein, das Gehäuse strahlungsabsorbierend auszurüsten. Mit Programmspeicherung versehene Speicherbauelemente, sog. PROM's sind gegen Röntgenstrahlen empfindlich, wie sie beispielsweise bei den Durchleuchtungen zur Flughafenabsicherung eingesetzt werden. Die Bestrahlung kann dazu führen, daß die gespeicherten Daten in solchen PROM's gelöscht werden. Da sich gerade Service-Techniker oft des Flugzeuges zur schnellen Behebung von Störungen bedienen, kann eine Ausführungsform der erfindungsgemäßen Aufnahmeeinrichtung vorteilhaft sein, bei der die Kassette oder das Gehäuse gegen Strahlung oder auch elektromagnetisch geschützt ist. Dies läßt sich durch geeignete Einlagen oder
Kaschierungen aus Blei bzw. nur der Leitfähigkeit dienenden Metallen erreichen.

Im folgenden wird die Erfindung anhand der in den Zeichnungen dargestellten Ausführungsbeispiele im einzelnen
zusätzlich erläutert. Es stellen dar:

Fig. 1   eine bevorzugte Aufnahmeeinrichtung in perspektivischer Ansicht und

Fig. 2   einen Schnitt durch die Trägerplatte dieser Aufnahmeeinrichtung.

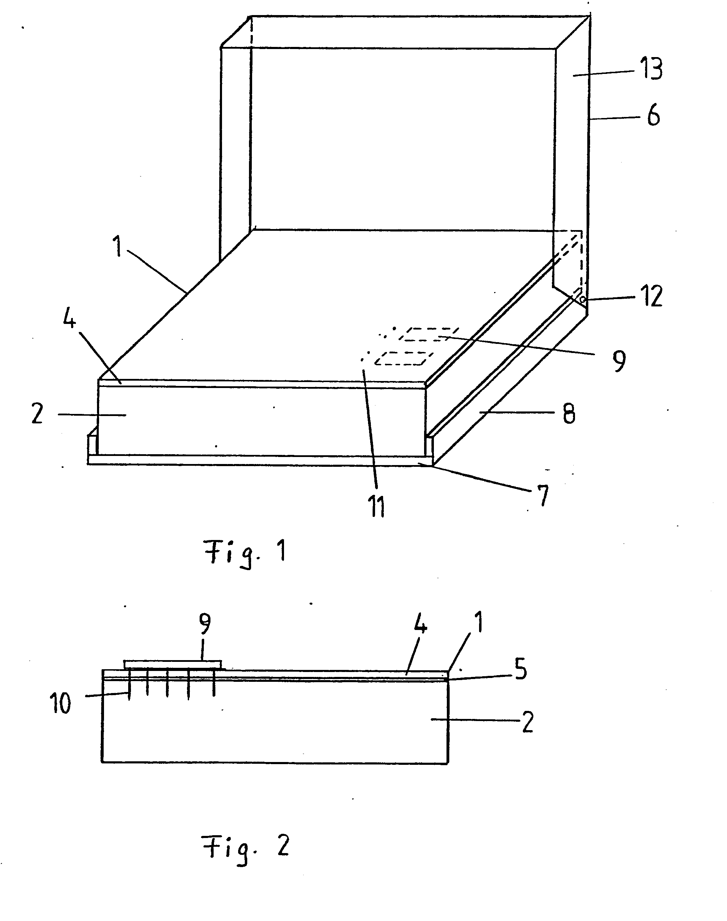

Die in Fig. 1 dargestellte Einrichtung zeigt eine rechteckige Einsteckplatte 1, die auf einer Bodenplatte 7 mit
seitlichen Begrenzungen 8 angeordnet ist. Die Bodenplatte 7
kann auch an den übrigen Seiten Begrenzungen aufweisen. Sie
ist mit einer klappbaren Schutzabdeckung 6 versehen, die in
diesem Ausführungsbeispiel ebenfalls seitliche Begrenzungen
13 aufweist. Die Verbindung der Schutzabdeckung 6 mit der
Bodenplatte 7 kann in bekannter Art und Weise, beispielsweise durch in der Schutzabdeckung 6 oder Bodenplatte 7
angeordnete Stifte 12 und entsprechende Öffnungen in der
Bodenplatte 7 bzw. Schutzabdeckung 6 ausgeführt sein. Die
Trägerplatte 1 besteht aus einer Hartschaumplatte 2 von
8 mm Diehl, auf die eine beschriftbare Aluminiumfolie 4 aufkaschiert ist. Die Dickenverhältnisse sind übertrieben dargestellt. In Fig. 1 sind auf der Folie 4 die Umrisse zweier
integrierter Schaltkreise 9 angedeutet, neben denen eine
ebenfalls angedeutete Kennzeichnungsbeschriftung 11 auf der
Oberfläche der Folie angebracht ist.

Fig. 2 zeigt die Einsteckplatte 1 im Querschnitt mit der
Hartschaumplatte 2 und der beschriftbaren Folie 4, die aus Aluminium besteht, sowie eine auf die Unterseite der Aluminiumfolie 4 aufkaschierte Papierschicht 5. Ein integrierter Schaltkreis 9 ragt mit seinen Anschlußbeinen 10 durch die Aluminiumfolie 4 hindurch in die Schaumstoffplatte 2 hinein und ist somit sicher gelagert. Durch die Aluminiumfolie 4 werden die Anschlußbeine des integrierten Schaltkreises 9 gegeneinander kurzgeschlossen, so daß eine Beschädigung der Bauelemente nicht möglich ist.

Die Verwendung steifer Hartschaumplatten bietet die Möglichkeit, daß die Aufnahmeeinrichtung, wenn sie von Bauelemente-Herstellern verwendet wird, auch maschinell bestückt werden kann.

0184849

Patentansprüche

1. Aufnahmeeinrichtung für elektronische Bauelemente, insbesondere integrierte Schaltkreise (9), welche mit im wesentlichen parallelen, vom Bauelement weggerichteten Anschlußbeinen (10) versehen sind, mit denen diese Bauelemente (9) in eine Fläche der Aufnahmeeinrichtung einsteckbar sind, die dieserhalb ein leicht von den Anschlußbeinen (10) durchbohrbares schaumstoffartiges Material (2) aufweist, wobei die Aufnahmeeinrichtung im Bereich der einzusteckenden Anschlußbeine (10) eine elektrische Leitfähigkeit aufweist, um die gehaltenen elektronischen Bauelemente (9) durch eine ladungsableitende gegenseitige elektrische Verbindung vor Schädigungen zu schützen, dadurch gekennzeichnet, daß diese Fläche der Aufnahmeeinrichtung eine von den Anschlußbeinen (10) durchstechbare, auf ihrer freien Außenoberfläche mit einem handelsüblichen Schreibgerät beschriftbare Folie (4) aufweist, unter der das schaumstoffartige Material (2) angeordnet ist, wobei diese Außenoberfläche einen genügend niedrigen Lichtabsorptionsgrad aufweist, um auf ihr angebrachte Informationen (11) mit genügendem Kontrast für das menschliche Auge erkennbar zu machen.

2. Aufnahmeeinrichtung nach Anspruch 1, dadurch gekennzeichnet, daß das schaumstoffartige Material eine Hartschaumplatte (2) ist, auf die die beschriftbare Folie (4) aufkaschiert ist.

3. Aufnahmeeinrichtung nach Anspruch 1 oder 2, dadurch gekennzeichnet, daß die beschriftbare Folie eine elektrisch leitende Folie (4) ist.

4. Aufnahmeeinrichtung nach Anspruch 3, dadurch gekennzeichnet, daß die beschriftbare Folie eine Kunststoffolie ist, die mit einer elektrisch leitenden Beschichtung, wie beispielsweise aus Zinnoxid oder Indiumoxid versehen ist.

5. Aufnahmeeinrichtung nach Anspruch 3, dadurch gekennzeichnet, daß die beschriftbare elektrisch leitende Folie eine Metall-, insbesondere Aluminiumfolie (4) ist.

6. Aufnahmeeinrichtung nach Anspruch 5, dadurch gekennzeichnet, daß die Aluminiumfolie (4) mit einer Papierschicht (5) kaschiert ist.

7. Aufnahmeeinrichtung nach Anspruch 5 oder 6, dadurch gekennzeichnet, daß die Hartschaumplatte beidseitig mit einer Aluminiumfolie versehen ist.

8. Aufnahmeeinrichtung nach einem der Ansprüche 1 bis 7, dadurch gekennzeichnet, daß die die Einsteckfläche aufweisende Platte (1) mit einem sie umgebenden verschließbaren Gehäuse (6, 7, 8, 13) versehen ist.

9. Aufnahmeeinrichtung nach Anspruch 8, dadurch gekennzeichnet, daß mehrere, eine Einsteckfläche aufweisende Platten (1) für eine Anordnung übereinander in einem kassettenartigen Gehäuse angeordnet sind.

10. Aufnahmeeinrichtung nach Anspruch 8 oder 9, dadurch gekennzeichnet, daß das Gehäuse mit einer elektrisch leitenden und/oder einer strahlungsabsorbierenden, insbesondere Röntgenstrahlen absorbierenden Beschichtung und/oder Einlage ausgerüstet ist.

Fig. 1

Fig. 2

**Europäisches Patentamt**

**EUROPÄISCHER RECHERCHENBERICHT**

0184849

Nummer der Anmeldung

EP 85115884.0

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US - A - 4 333 565 (WOODS)<br>* Spalte 3, Zeilen 16-25 *<br>-- | 1-4,8 | H 01 L 23/54<br>H 05 F 3/02<br>B 65 D 85/42 |
| X | US - A - 4 274 537 (COOPER)<br>* Spalte 3, Zeilen 1-15,46-61 *<br>-- | 1,8,9 | |
| A | US - A - 4 487 315 (AZUMA)<br>* Spalte 1, Zeile 62 *<br>-- | 1,4 | |
| A | US - A - 3 092 245 (POISSON)<br>* Gesamt *<br>-- | 1,8 | |
| A | US - A - 2 518 450 (OWEN)<br>* Gesamt *<br>-- | 1,8 | **RECHERCHIERTE SACHGEBIETE (Int. Cl.4)** |
| A | US - A - 4 404 615 (DEP)<br>* Spalte 3, 1. Absatz *<br>---- | 1,10 | B 65 D<br>H 01 L<br>H 05 F<br>H 05 K |

Der vorliegende Recherchenbericht wurde für alle Patentansprüche erstellt.

| Recherchenort | Abschlußdatum der Recherche | Prüfer |
|---|---|---|
| WIEN | 04-03-1986 | HEINICH |